Europäisches Patentamt

European Patent Office

Office européen des brevets

(11) Veröffentlichungsnummer: **0 111 227**
**A2**

(12) # EUROPÄISCHE PATENTANMELDUNG

(21) Anmeldenummer: **83111831.0**

(22) Anmeldetag: **25.11.83**

(51) Int. Cl.³: **G 03 F 1/00**

(30) Priorität: **11.12.82 DE 3245867**

(43) Veröffentlichungstag der Anmeldung:
**20.06.84** Patentblatt **84/25**

(84) Benannte Vertragsstaaten:
**AT BE CH DE FR GB IT LI LU NL SE**

(71) Anmelder: **EUROSIL electronic GmbH**
**Erfurter Strasse 16**
**D-8057 Eching(DE)**

(72) Erfinder: **Fischer, Gerhard, Dr.**
**Johann-Schmid-Strasse 25**
**D-8044 Unterschleissheim(DE)**

(72) Erfinder: **Wehrli, Martin**
**Blumenstrasse 7**
**D-8043 Unterföhring(DE)**

(74) Vertreter: **Schaumburg, Schulz-Dörlam & Thoenes**
**Mauerkircherstrasse 31 Postfach 86 07 48**
**D-8000 München 86(DE)**

(54) **Spannungsarme, thermisch unempfindliche Trägerschicht für eine Absorberstruktur einer Bestrahlungsmaske für Röntgenlithographie.**

(57) Die vorliegende Erfindung betrifft eine spannungsarme, thermisch unempfindliche Trägerschicht 1 für eine Absorberstruktur 2 einer Bestrahlungsmaske für Röntgenlithographie, sowie ein Herstellungsverfahren für eine derartige Trägerschicht 1. Dabei ist die Trägerschicht 1 aus mindestens drei Schichten mit unterschiedlichen Eigenschaften aufgebaut, wobei diese Schichten vorzugsweise aus Material gleicher Zusammensetzung, jedoch mit unterschiedlichen physikalischen Eigenschaften bestehen. Die gesamte Trägerschicht 1 ist dabei symmetrisch zu ihrer Schichtmitte 5 aufgebaut, d. h. die beiden Oberflächenschichten 3,3' bestehen aus identischem Material und weisen identische Abmessungen auf. Durch Auswahl geeigneter Materialkombinationen für die Oberflächenschichten 3,3' und die eine oder mehreren Zwischenschichten 4 kann beispielsweise erreicht werden, daß Materialspannungen nach außen hin kompensiert sind. Ein Bimetalleffekt kann durch den symmetrischen Aufbau bei einer Erwärmung der Trägerschicht nicht auftreten.

FIG. 1

Spannungsarme, thermisch unempfindliche Trägerschicht
für eine Absorberstruktur einer Bestrahlungsmaske für
Röntgenlithographie

Die vorliegende Erfindung betrifft eine spannungsarme,
thermisch unempfindliche Trägerschicht gemäß dem Oberbegriff des Anspruches 1.

Derartige Trägerschichten sind bekannt.

Aus der DE-PS 23 46 719 ist eine mehrschichtig aufgebaute Bestrahlungsmaske für die Röntgenlithographie
entnehmbar. Diese Maske besteht aus einem Siliziumkörper, welcher auf der einen Breitseite seiner Oberfläche mit einer Trägerschicht belegt ist. Diese Trägerschicht besteht dabei aus einer $SiO_2$ - Schicht und einer
Stützschicht aus Polyimid. Dabei weist die Stützschicht
eine Dicke zwischen 3 und 10 µm und die $SiO_2$ -Schicht
eine Dicke von etwa 5 µm auf. Auf der Stützschicht werden die maskierenden Strukturen aus röntgenabsorbierenden Material, z. B. aus Gold aufgebracht. Der Siliziumkörper wird an den Stellen, an denen sich die maskierenden Strukturen befinden, selektiv bis zur $SiO_2$ -Schicht abgeätzt. Durch die so entstandenen Fenster kann eine Belichtung mittels Röntgenstrahlung erfolgen.

Wie sich auch aus dem vorstehenden ergibt, besteht eine Bestrahlungsmaske für die Röntgenlithographie im Wesentlichen aus zwei Teilen, nämlich der für Röntgenstrahlen im relevanten Bereich (Wellenlänge zwischen etwa 2 Å und maximal 100 Å) möglichst durchlässigen Trägerschicht, welche daher sehr dünn sein muß, und der für die gleiche Röntgenstrahlung möglichst undurchlässigen Absorberschicht, die die eigentliche Markierung bildet.

Als geeignete Stoffe für die Trägerschicht sind verschiedene Kunststoffolien bekannt, aber auch Materialien auf Siliziumbasis ($p^+$dotiertes Si, $Si_3N_4$ oder $Si_3N_4$ + $SiO_2$, $SiO_2$ usw.) oder auch auf Metallbasis (Be, Al, $Al_2O_3$ usw.) die in verschiedenen Dicken - abhängig von ihrer jeweiligen Röntgenabsorption - eingesetzt werden können. Alle diese Materialien absorbieren nun während der Belichtungszeit Röntgenstrahlung und erwärmen sich dadurch, bzw. werden durch Wärmeübertragung von der Absorberschicht erwärmt.

Da die Trägerschichten aus Gründen geringer Röntgenabsorption auch möglichst dünn sein müssen (materialabhängig zwischen etwa 0,1 und 25 μm) ist ihre mechanische Stabilität im allgemeinen gering und kann bei Erwärmung zu Verspannungen, Verzugserscheinungen und sogar zu Rissen oder Brüchen führen.

Um die mechanische Stabilität der Trägerschicht zu erhöhen, ist es nun möglich, wie aus der eingangs genannten DE-PS 23 46 719 bekannt, die Trägerschicht aus zwei verschiedenen Materialien aufzubauen, deren physikalischmechanische Eigenschaften sich hinsichtlich der Anforderungen an eine derartige Bestrahlungsmaske ergänzen. Durch den zweischichtigen Aufbau aus Materialien mit unterschiedlichen Wärmeausdehnungskoeffizienten kommt es jedoch bei einer Erwärmung der Trägerschicht immer noch zu einer mehr oder weniger starken Durchbiegung (Bimetalleffekt), die die Abbildungsqualität einer Bestrahlungsmaske mit einer derartigen Trägerschicht erheblich verringert.

Bei Trägerschichten aus einem einzigen Material tritt dieser Bimetalleffekt nicht auf. Insbesondere bei Trägerschichten auf Metall- oder Siliziumbasis kann es jedoch zu herstellungsbedingten Materialspannungen kommen, die bei Erwärmung der Bestrahlungsmaske zu Verwerfungen und Verbiegungen führen, was der Abbildungsqualität ebenfalls abträglich ist. Weiterhin erlauben diese Materialspannungen nur relativ kleinflächige Trägerschichten ohne zu Rissen o.ä. in der Trägerschicht oder in der darauf aufgebrachten Absorberstruktur zu führen.

Es ist daher Aufgabe der vorliegenden Erfindung, den Aufbau und ein Herstellungsverfahren für eine derartige Trägerschicht anzugeben, welche keine oder nur vernachlässigbare, oder aber in ihrer Größe und Art vorgebbare nach außen dringende Materialspannungen und keinen oder einen vernachlässigbaren Bimetalleffekt bei Erwärmung aufweist. Weiterhin sollen freitragende Trägerschichten in für heutige ICs üblichen Größen realisierbar sein.

Die Aufgabenstellung wird dadurch gelöst, daß eine Trägerschicht der eingangs genannten Artt gemäß den kennzeichnenden Merkmalen des Anspruches 1 aausgestaltet wird.

Dabei ergibt sich durch den mehrschichtiigen Aufbau der Vorteil einer hohen mechanischen Stabiliität; durch Auswahl geeigneter Materialien, die sich im ihren Eigenschaften gegenseitig entsprechend ergänzzen, sind Trägerschichten herstellbar, die hohen mechaniischen und thermischen Anforderungen genügen. Durchn den symmetrischen Aufbau der Trägerschicht mit identischerm Oberflächenschichten tritt praktisch kein Bimetalleeffekt mehr bei einer Erwärmung auf.

Weitere Vorteile sind den Unteransprücheen entnehmbar:

So kann in vorteilhafter Weise die Trägeerschicht aus mehreren Schichten eines einzigen Materiials aufgebaut sein, wobei sich die einzelnen Schichtem nur durch physikalische Eigenschaften – bei im Wessentlichen gleicher chemischer Zusammensetzung – unterscheiden.. Die Unterschiede können dabei zum Beispiel durch unterschniedliche Aufbringungsverfahren für die einzelnen Schnichten erreichbar sein. Ein derartiger Aufbau kann vorrzugsweise für Trägerschichten auf Silizium-Basis angewwendet werden. Wird dabei zusätzlich als Substratbei deer Herstellung der Trägerschicht ein Siliziumwafer verwwendet, so kann bei der Herstellung der Trägerschicht auuf das "Silizium-Know-how" aus der Halbleiterherstellung zzurückgegriffen werden.

Ein besonders bevorzugtes Ausführungsbeiispiel verwendet daher als Material für die Trägerschicht Siliziumnitrid, welches für die einzelnen Schichten mitttels zweier an sich bekannter Verfahren aufgebracht wirrd, nämlich dem LPCVD- Verfahren (Low Pressure Chemical Vapor Deposition) und dem PECVD-Verfahren (Plasma Enhanced Chemical Vapor Deposition). Bei nach einem dieser Verfahren hergestellten Siliziumnitridschichten treten Zugspannungen (LPCVD-Verfahren) und Druckspannungen (PECVD-Verfahren) innerhalb der jeweiligen Schicht auf. Wird nun ein besonders einfacher Aufbau der Trägerschicht gewählt, so werden beispielsweise die beiden Oberflächenschichten der Trägerschicht nach dem LPCVD-Verfahren und eine dazwischenliegende einzelne Schicht nach dem PECVD-Verfahren hergestellt. Bei einem geeigneten Verhältnis der Gesamtdicke von LPCVD-, bzw. PECVD-Schichten, vorzugsweise zwischen 1 : 5 und 1 : 10, wird erreicht, daß sich die vorhandenen Zug- und Druckspannungen nach außen vollständig kompensieren, so daß damit sehr dünne Siliziumnitrid-Trägerschichten (Dicke zwischen etwa 0,5 und 2 µm) mit für die heutige und die zukünftige IC-Fertigung notwendigen Flächen auch oberhalb 2000 mm$^2$ zur Verfügung gestellt werden können. So ist es auch möglich, auf einer zusammenhängenden Trägerschichtfläche die Masken für mehrere ICs unterzubringen.

Das Herstellungsverfahren für eine derartige Schicht ist einfach und aufgrund des anwendbaren "Silizium-Know-hows" problemlos. Besonders vorteilhaft ist dabei, daß zumindest ein Teil der Siliziumnitridschichten auf Vorder- und Rückseite im gleichen Verfahrensschritt aufgebracht werden können, wobei das auf der Rückseite aufgebrachte Siliziumnitrid - nach einem Fotoschritt zur Freilegung geeigneter Bereiche - als Ätzmaske dient. Dabei kann als Ätzmittel in äußerst vorteilhafter Weise in Wasser gelöstes Kaliumhydroxid verwendet werden, welches Siliziumnitrid praktisch nicht angreift. Außerdem ist Siliziumnitrid optisch transparent, was für die Justierung bei der Anwendung der fertigen Bestrahlungsmaske sehr vorteilhaft ist.

Weitere Vorteile sind der Beschreibung entnehmbar.

Die Erfindung soll nun im Folgenden anhand der Zeichnung näher erläutert werden. Im Einzelnen zeigt

Fig. 1 eine schematische Darstellung einer dreischichtigen Trägerschicht

Fig. 2 bis Fig. 7 die verschiedenen Stadien während der Herstellung eines bevorzugten Ausführungsbeispiels einer Trägerschicht unter Verwendung eines Wafers.

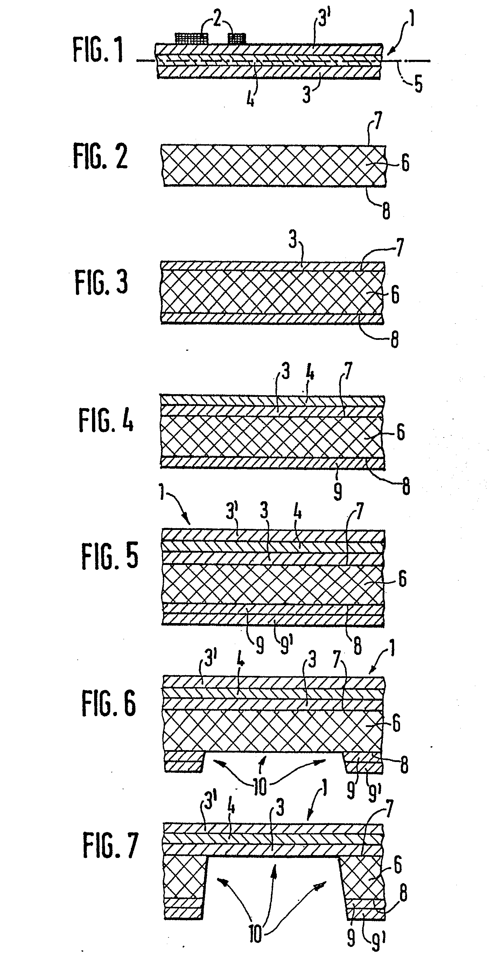

In Fig. 1 ist eine erfindungsgemäße Trägerschicht 1 für eine Absorberstruktur 2 schematisch dargestellt. Derartige Trägerschichten 1 mit darauf angeordneten Absorberstrukturen 2 werden als Bestrahlungsmasken für röntgenlithographische Verfahrensschritte bei der Herstellung von feinsten Halbleiterstrukturen benötigt.

Die Trägerschicht 1 besteht aus zwei Oberflächenschichten 3,3;die die gleiche Dicke aufweisen und aus identischem Material bestehen. Zwischen den beiden Oberflächenschichten 3,3'befindet sich mindestens eine weitere Zwischenschicht 4, welche sich hinsichtlich ihrer physikalischen und/oder chemischen Eigenschaften von den Oberflächenschichten 3,3' unterscheidet. Im Sinne der Erfindung ist es auch möglich, mehr als eine Zwischenschicht 4 zwischen den Oberflächenschichten 3,3' einzubauen. Die relevante Bedingung dabei ist, daß der Gesamtaufbau der Trägerschicht 1 im Wesentlichen symmetrisch zu einer Ebene durch die Schichtmitte 5 der Trägerschicht 1 ist. Dabei bezieht sich diese Symmetrie sowohl auf die Geometrie der Schichtfolge aus Oberflächenschichten 3,3' und Zwischenschichten 4, als auch auf deren Materialzusammensetzung.

Vorzugsweise werden als Materialien für den Aufbau der Trägerschicht 1 die bereits genannten Stoffe auf Metall- und/oder Siliziumbasis verwendet. Dabei werden vorzugsweise Stoffpaarungen gewählt, die sich hinsichtlich ihrer Eigenschaften für die gestellten Anforderungen ergänzen.

Ein bevorzugtes Ausführungsbeispiel verwendet dabei eine Materialpaarung, bei der ein Stoff, insbesondere Siliziumnitrid, in im Wesentlichen gleicher chemischer Zusammensetzung sowohl für die Oberflächenschichten 3,3' als auch als einzige Zwischenschicht 4 Verwendung findet. Die Oberflächenschichten 3,3' und die Zwischenschicht 4 werden dabei jedoch nach verschiedenen Verfahren hergestellt, wodurch sie unterschiedliche physikalische Eigenschaften aufweisen. Dabei werden die Oberflächenschichten 3,3' insbesondere aus nach dem bereits erwähnten LPCVD-Verfahren hergestellten Siliziumnitrid-Schichten gebildet, während die Zwischenschicht 4 nach dem bereits erwähnten PECVD-Verfahren hergestellt ist. Wie Untersuchungen von Schichten aus Siliziumnitrid, die nach diesen beiden Verfahren hergestellt wurden, ergeben haben, entstehen bei nach dem LPCVD-Verfahren hergestellten Schichten Zugspannungen in der Schicht, während bei Schichten, die nach dem PECVD-Verfahren hergestellt wurden, Druckspannungen entstehen. Analysen einer mittels des PECVD-Verfahrens abgeschiedenen Siliziumnitrid-Schicht ergaben, daß nicht - stöchiometrisches Siliziumnitrid vorlag (Atomkonzentrationen $Si/N \gtrsim 0,75$).

Offenbar werden während der Herstellung einer derartigen Schicht Wasserstoffradikale eingebaut, wodurch die mechanischen Eigenschaften der Schicht beeinflußt werden. Nach dem LPCVD-Verfahren hergestellte Siliziumnitrid-Schichten bestehen dagegen aus stöchiometrischen Siliziumnitrid.

Werden die beiden Oberflächenschichten 3,3' aus LPCVD-Siliziumnitrid gleicher Dicke hergestellt, und die Zwischenschicht 4 aus PECVD-Siliziumnitrid, so kann durch Vorgabe einer bestimmten Dicke der Zwischenschicht 4 erreicht werden, daß die Materialspannungen nach außen hin kompensiert sind. Es ist aber auch möglich, durch geeignete Wahl des Gesamtdickenverhältnisses zwischen Oberflächenschichten 3,3' und Zwischenschicht 4 eine definierte Materialspannung zu erzielen.

Dies kann vorteilhaft sein, wenn durch das Aufbringen der Absorberstruktur 2 ebenfalls Materialspannungen in der Bestrahlungsmaske erzeugt werden, welche dann gegebenenfalls durch eine entsprechende Voreinstellung der Trägerschicht 1 kompensiert werden. Vorzugsweise wird bei dem Gesamtdickenverhältnis zwischen LPCVD- und PECVD-Siliziumnitridschichten ein Wertebereich zwischen etwa 1 : 5 und 1 : 10 bei einer Gesamtdicke der Schicht zwischen 0,5 µm und 2 µm verwendet.

Im folgenden wird anhand der Fig. 2 bis 7, welche die verschiedenen Stadien während der Herstellung einer Trägerschicht darstellen, ein bevorzugtes Herstellungsverfahren für eine spannungsarme, thermisch unempfindliche Trägerschicht 1 gemäß der Erfindung beschrieben.

Fig. 2 zeigt einen Ausschnitt aus einen Wafer 6, welcher als Substrat für die Herstellung der Trägerschicht 1 und später als tragender Rahmen zwischen den einzelnen Fenstern der Bestrahlungsmaske dient. Vorzugsweise wird als Material für den Wafer 6 eine (100)-Siliziumscheibe verwendet, welche zumindest einseitig poliert ist. Diese polierte Seite wird als Vorderseite 7, und die gegebenenfalls nicht polierte Seite als Rückseite 8 des Wafers 6 bezeichnet.

Auf die Vorderseite 7 und vorzugsweise auch auf die Rückseite 8 wird im gleichen Verfahrensschritt eine erste Schicht Siliziumnitrid aufgebracht, welche auf der Vorderseite 7 als erste Oberflächenschicht 3 der Trägerschicht 1 und auf der Rückseite 8 als erste Ätzmaskenschicht 9 verwendet wird (siehe Fig. 3). Bei diesem Verfahrensschritt wird das Siliziumnitird vorzugsweise nach dem LPCVD-Verfahren aufgebracht.

Im nächsten Verfahrensschritt (Fig. 4) wird das Siliziumnitrid vorzugsweise im PECVD-Verfahren und vorzugsweise nur auf der Vorderseite 7 (bzw. auf der durch die erste Oberflächenschicht 3 bedeckten Vorderseite 7) des Wafers 6 aufgebracht. Die so aufgebrachte Schicht dient als Zwischenschicht 4 der Trägerschicht 1.

Danach wird eine weitere Schicht Siliziumnitrid auf die bisher aufgebrachten Schichten vorzugsweise im LPCVD-Verfahren vorzugsweise vorder- und rückseitig aufgebracht (Fig. 5). Der Wafer 6 ist demnach jetzt auf seiner Vorderseite 7 mit einer Schichtfolge aus LPCVD-, PECVD-, LPCVD-Siliziumnitrid bedeckt, wobei die zuletzt aufgebrachte Schicht die zweite Oberflächenschicht 3′ der Trägerschicht 1 bildet, und die gesamte Schichtfolge auf der Vorderseite 7 des Wafers 6 die Trägerschicht 1 bildet. Die auf der Rückseite 8 des Wafers 6 aufgebrachten ein oder zwei Schichten auf LPCVD-Siliziumnitrid dienen als erste, und gegebenenfalls als zweite Ätzmaskenschicht 9,9′.

In den nächsten Verfahrensschritten muß nunmehr die Trägerschicht 1 von beiden Seiten zugänglich gemacht werden. Dazu muß ein Teil des Materials des Wafers 6 in der Größe des zukünftigen Maskenfensters entfernt werden. Dazu wird als Hilfsmittel die Ätzmaskenschicht 9,9' verwendet. Ein vorgegebener Fensterbereich 10 aus der Ätzmaskenschicht 9,9' wird mittels eines herkömmlichen Fotoschrittes in einfachster Weise entfernt , so daß im Fensterbereich 10 die Rückseite des Wafers 6 frei liegt (siehe Fig. 6). Danach erfolgt die Abtragung des Materials des Wafers 6 innerhalb des Fensterbereiches 10, bis die erste Oberflächenschicht 3 der Trägerschicht 1 freigelegt ist (Fig. 7). Dies erfolgt vorzugsweise durch Abätzen mittels Ätzmitteln, welche den Wafer 6 senkrecht zur Waferebene mit hoher Geschwindigkeit lösen, während das Material der Trägerschicht nicht oder nur wenig angegriffen wird.

Bei der bevorzugten Verwendung eines (100)-Si-Wafers 5 und von Siliziumnitrid für die Trägerschicht 1 und die Ätzmaskenschichten 9,9' ist mittels in Wasser gelöstem Kaliumhydroxid ein völlig unkritischer Ätzschritt möglich. So beträgt bei einer 27 %igen Kaliumhydroxidlösung bei einer Ätztemperatur von 107$^o$ C die Ätzrate für 100-Silizium etwa 4,2 µm/min, während die Ätzrate für 111-Silizium etwa zwanzig Mal kleiner ist und Siliziumnitrid praktisch nicht angegriffen wird. Es kommt daher auch nicht zu einem Unterätzen der Ätzmaskenschicht 9,9'.

Im nunmehr freigelegten Fensterbereich 10 kann auf eine oder beide der Obeflächenschichten 3,3' der Trägerschicht 1 eine Absorberstruktur 2 in bekannter Weise aufgebracht werden. Die nicht abgeätzten Teile des Wafers 6 außerhalb des, bzw. der Fensterbereiche 10 dienen bei der fertigen Bestrahlungsmaske als stabilisierender Stützrahmen für die Trägerschicht 1.

Patentansprüche

1. Spannungsarme, thermisch unempfindliche Trägerschicht
für eine Absorberstruktur einer Bestrahlungsmaske
für Röntgenlithographie aus mindestens zwei Materialschichten mit unterschiedlichen Eigenschaften,
dadurch gekennzeichnet,
daß die Trägerschicht (1) aus mindestens drei Schichten
aufgebaut ist, wobei die beiden Oberflächenschichten
(3,3´) aus identischen Material bestehen und der
Gesamtaufbau der Trägerschicht (1) im Wesentlichen
symmetrisch zu einer Ebene durch die Schichtmitte
(5) der Trägerschicht (1) ist.

2. Spannungsarme, thermisch unempfindliche Trägerschicht
nach Anspruch 1,
dadurch gekennzeichnet,
daß die Trägerschicht (1) aus mindestens drei Schichten
mit jeweils im Wesentlichen gleicher chemischer Zusammensetzung aufgebaut ist und die Oberflächenschichten (3,3´)
andere physikalische Eigenschaften aufweisen, als
die zwischen ihnen angeordnete eine oder mehrere
Zwischenschichten (4).

3. Spannungsarme, thermisch unempfindliche Trägerschicht nach Anspruch 2,
dadurch gekennzeichnet,

daß die einzelnen Schichten der Trägerschicht (1)
aus Siliziumnitrid bestehen, welches bei den einen
Schichten mittels LPCVD-Verfahren und bei den anderen Schichten mittels PECVD-Verfahren hergestellt
ist.

4. Spannungsarme, thermisch unempfindliche Trägerschicht nach einem der Ansprüche 1 bis 3,
dadurch gekennzeichnet,
daß das Verhältnis der Gesamtdicken der jeweils nach
einem Verfahren hergestellten Schichten derart
vorgegeben ist, daß unterschiedliche physikalische
Eigenschaften dieser Schichten, vorzugsweise herstellungsbedingte und thermische Spannungen, nach
außen hin kompensiert sind.

5. Spannungsarme, thermisch unempfindliche Trägerschicht nach Anspruch 3 oder 4,
dadurch gekennzeichnet,
daß das Verhältnis der Gesamtdicken von LPCVD- und
PECVD-Schichten zwischen etwa 1 : 5 und 1 : 10 liegt.

6. Spannungsarme, thermisch unempfindliche Trägerschicht nach einem der Ansprüche 3 bis 5,
dadurch gekennzeichnet,
daß die beiden Oberflächenschichten (3,3') der
Trägerschicht (1) von LPCVD-Schichten gleicher
Dicke gebildet sind, zwischen die eine einzige
PECVD-Zwischenschicht (4) eingelagert ist.

7. Herstellungsverfahren für eine spannungsarme, thermisch unempfindlciihe Trägerschicht nach einem der Ansprüche 3 bis 6, dadurch gekennzeichnet, daß ein Wafer (6) , vorzugsweise ein Wafer (6) aus einseitig polierten (100)-Silizium, mindestens auf einer polierten Vorderseite (7) zur Ausbildung der Trägerschicht (1) mit einer Schichtfolge aus Siliziumnitrid versehen wird, wobei ein Teil der Schichten nach dem LPCVD-Verfahren und der andere Teil nach dem PECVD-Verfahren hergestellt wird,

daß zumindest ein Teil dieser Schichtfolge gleichzeitig auch auf die Rückseite (8) des Wafers (6) aufgebracht wird,

daß die auf der Rückseite (8) aufgebrachte Schichtfolge in einem Fotoschritt teilweise, vorzugsweise innerhalb geschlossener Bereiche, entfernt wird und als Ätzmaske zum vollständigen Wegätzen des Wafermaterials an den offenen Stellen dient, wobei die Trägerschicht (1) freigelegt wird.

8. Herstellungsverfahren nach Anspruch 7, dadurch gekennzeichnet, daß als erste Oberflächenschicht (3) Siliziumnitrid nach dem LPCVD-Verfahren, als Zwischenschicht (4) Siliziumnitrid nach dem PECVD-Verfahren und als zweite Oberflächenschicht (3') Siliziumnitrid nach dem LPCVD-Verfahren auf die Vorderseite (7) des Wafers (6) aufgebracht wird und daß gleichzeitig mit der Aufbringung der ersten und/oder zweiten Oberflächenschicht (3,3') gleichartige Schichten auch auf die Rückseite (8) des Wafers (6) aufgebracht werden.

9. Herstellungsverfahren nach Anspruch 7 oder 8, dadurch gekennzeichnet, daß das Material des Wafers (6) mittels in Wasser gelöstem Kaliumhydroxid geätzt wird.

1/1

FIG. 1

FIG. 2

FIG. 3

FIG. 4

FIG. 5

FIG. 6

FIG. 7